(19) Europäisches Patentamt / European Patent Office / Office européen des brevets

(11) **EP 3 658 926 B1**

(12) **FASCICULE DE BREVET EUROPEEN**

(45) Date de publication et mention
de la délivrance du brevet:
**07.04.2021 Bulletin 2021/14**

(21) Numéro de dépôt: **18740852.1**

(22) Date de dépôt: **18.07.2018**

(51) Int Cl.:
*G01R 31/08* (2020.01)   *G01R 31/11* (2006.01)

(86) Numéro de dépôt international:
**PCT/EP2018/069468**

(87) Numéro de publication internationale:
**WO 2019/020448 (31.01.2019 Gazette 2019/05)**

(54) **SYSTEME DE REFLECTOMETRIE POUR L'ANALYSE DE DEFAUTS DANS AU MOINS UNE LIGNE DE TRANSMISSION, LE SYSTEME COMPRENANT UN CORRELATEUR COMPLEXE**

REFLEKTOMETRIESYSTEM ZUR ANALYSE VON DEFEKTEN BEI MINDESTENS EINER ÜBERTRAGUNGSLEITUNG MIT EINEM KOMPLEXEN KORRELATOR

REFLECTOMETRY SYSTEM FOR ANALYSING DEFECTS IN AT LEAST ONE TRANSMISSION LINE, THE SYSTEM COMPRISING A COMPLEX CORRELATOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.07.2017 FR 1757181**

(43) Date de publication de la demande:
**03.06.2020 Bulletin 2020/23**

(73) Titulaire: **Commissariat à l'Énergie Atomique et aux Énergies Alternatives**
**75015 Paris (FR)**

(72) Inventeurs:
• **LAYER, Christophe**
**75015 Paris (FR)**
• **CABANILLAS, Esteban**
**91400 Orsay (FR)**
• **CARTRON, Mickael**
**91400 Orsay (FR)**

(74) Mandataire: **Marks & Clerk France**
**Immeuble "Visium"**
**22, avenue Aristide Briand**
**94117 Arcueil Cedex (FR)**

(56) Documents cités:
**FR-A1- 3 006 769       US-A- 5 787 128**
**US-A1- 2004 183 544    US-A1- 2010 073 014**
**US-A1- 2010 188 095**

**Description**

L'invention concerne le domaine des systèmes de diagnostic filaire basés sur le principe de la réflectométrie. Elle concerne plus précisément un tel système comprenant un dispositif de corrélation configuré pour réaliser simultanément deux corrélations d'un signal de référence respectivement avec deux mesures de réflectométrie distinctes. Un tel dispositif est utilisé pour augmenter les capacités de traitement du système, par exemple le nombre de lignes de transmission surveillées en parallèle ou la vitesse de traitement des signaux reçus par le système.

Les câbles sont omniprésents dans tous les systèmes électriques, pour l'alimentation ou la transmission d'information. Ces câbles sont soumis aux mêmes contraintes que les systèmes qu'ils relient et peuvent être sujets à des défaillances. Il est donc nécessaire de pouvoir analyser leur état et d'apporter des informations sur la détection de défauts, mais aussi leur localisation et leur type, afin d'aider à la maintenance. Les méthodes de réflectométrie usuelles permettent ce type de tests.

Les méthodes de réflectométrie utilisent un principe proche de celui du radar : un signal électrique, le signal de sonde ou signal de référence, qui est le plus souvent de haute fréquence ou large bande, est injecté en un ou plusieurs endroits du câble à tester. Le signal se propage dans le câble ou le réseau et renvoie une partie de son énergie lorsqu'il rencontre une discontinuité électrique. Une discontinuité électrique peut résulter, par exemple, d'un branchement, de la fin du câble ou d'un défaut ou plus généralement d'une rupture des conditions de propagation du signal dans le câble. Elle résulte d'un défaut qui modifie localement l'impédance caractéristique du câble en provoquant une discontinuité dans ses paramètres linéiques.

L'analyse des signaux renvoyés au point d'injection permet d'en déduire des informations sur la présence et la localisation de ces discontinuités, donc des défauts éventuels. Une analyse dans le domaine temporel ou fréquentiel est habituellement réalisée. Ces méthodes sont désignées par les acronymes TDR venant de l'expression anglo-saxonne « Time Domain Reflectometry » et FDR venant de l'expression anglo-saxonne « Frequency Domain Reflectometry ».

Le document FR 3 006 769 A1 concerne un procédé de réflectométrie pour l'identification de défauts non francs impactant un câble. Le procédé se base sur le calcul de l'atténuation d'un signal se propageant le long du câble sous test pour élaborer une fonction de détection dans laquelle les pics d'amplitude associés aux défauts non francs sont renforcés.

L'invention entre dans le champ d'application des méthodes de diagnostic filaire et s'applique à tout type de câble électrique, en particulier des câbles de transmission d'énergie ou des câbles de communication, dans des installations fixes ou mobiles. Les câbles concernés peuvent être coaxiaux, bifilaires, en lignes parallèles, en paires torsadées ou autre, pourvu qu'il soit possible d'y injecter un signal de réflectométrie en un point du câble et de mesurer sa réflexion au même point ou en un autre point.

Un système de réflectométrie est habituellement utilisé pour diagnostiquer l'état de santé d'une ligne de transmission, par exemple un câble unique, en connectant le système en un point du câble. Cependant, dans le cas d'installations complexes, par exemple d'un réseau de câbles de transmission d'énergie, d'alimentation ou de communication, dans un immeuble ou un véhicule, par exemple un aéronef, les câbles peuvent être regroupés en liasses de câbles. Pour analyser chaque câble d'une liasse, il faut alors connecter successivement le système à chacun des câbles. Une telle procédure engendre un temps de traitement qui peut être rédhibitoire en particulier lorsque le temps d'accès aux installations est limité. Par exemple, pour le cas d'un véhicule, tel qu'un aéronef, le temps d'analyse des câbles à bord du véhicule impacte le temps global pendant lequel le véhicule ne peut être utilisé. Par ailleurs, lorsqu'il s'agit de détecter des défauts intermittents, c'est-à-dire de courte durée, intervenant sur plusieurs câbles simultanément, l'utilisation d'un seul appareil de diagnostic ne permet pas une analyse suffisamment rapide. En effet, dans un tel scénario, l'appareil de diagnostic est associé à un système de commutation pour connecter successivement l'appareil aux différents câbles. La commutation temporelle ainsi réalisée affecte la capacité à détecter des défauts dont la durée est courte par rapport au temps de commutation proportionnel au nombre de câbles à diagnostiquer.

Un autre problème est lié aux capacités de traitement d'un système de réflectométrie. Un tel système comporte en général un convertisseur numérique-analogique pour convertir le signal de référence numérique en un signal analogique pour l'injecter dans le câble, un convertisseur analogique-numérique pour réaliser l'opération inverse sur le signal mesuré et un corrélateur qui réalise le calcul de l'inter-corrélation entre le signal de référence et le signal mesuré. Le corrélateur peut être implémenté sur un processeur ou sur un circuit intégré du type ASIC ou FPGA. Du fait des limitations technologiques, la fréquence de traitement ou fréquence d'horloge du dispositif qui implémente la fonction de corrélation est généralement inférieure à la fréquence d'échantillonnage du convertisseur analogique-numérique. En effet, l'opération de calcul d'inter-corrélation nécessite un nombre d'opérations important et les modules de calcul numérique (qu'ils soient implémentés via un processeur numérique ou un circuit intégré) ne sont généralement pas capables de fonctionner à des fréquences aussi élevées qu'un convertisseur analogique-numérique. De ce fait, il n'est pas possible de traiter le signal en sortie du convertisseur analogique-numérique à la vitesse à laquelle il est reçu.

Il existe donc un problème général consistant à augmenter les capacités de traitement d'un système de réflectométrie pour permettre de traiter plusieurs lignes de transmission simultanément mais aussi pour permettre un calcul de la fonction de corrélation à un rythme proche ou égal à la fréquence d'échantillonnage du signal reçu.

L'invention propose un système de réflectométrie comprenant un ou plusieurs corrélateurs complexes dont les deux voies de corrélation, correspondant respectivement à la partie réelle et à la partie imaginaire du signal complexe, sont exploitées afin de résoudre les problèmes techniques introduits ci-dessus.

L'invention a ainsi pour objet un système de réflectométrie pour l'analyse de défauts dans un groupe de lignes de transmission comprenant au moins une ligne, un signal de référence réel généré étant injecté dans chaque ligne de transmission dudit groupe, ledit système comprenant :

- au moins un moyen de mesure du signal de référence rétro-propagé dans chaque ligne de transmission dudit groupe,
- au moins un convertisseur analogique-numérique pour convertir au moins un signal mesuré en un ensemble d'au moins un premier signal numérique et un deuxième signal numérique,
- au moins un corrélateur complexe configuré pour corréler le signal de référence réel avec un signal complexe dont la partie réelle est formée par un premier signal numérique dudit ensemble et la partie imaginaire est formée par un deuxième signal numérique dudit ensemble, afin de produire un premier réflectogramme correspondant à la partie réelle du signal complexe et un second réflectogramme correspondant à la partie imaginaire du signal complexe,
- Un module d'analyse d'au moins le premier réflectogramme et le second réflectogramme pour identifier la présence de défauts dans au moins une ligne de transmission dudit groupe.

Selon un aspect particulier de l'invention, un corrélateur complexe comprend un premier module de transformée de Fourier apte à recevoir sur une entrée le signal de référence et dont la seconde entrée est mise à zéro, un second module de transformée de Fourier apte à recevoir le premier signal numérique sur une première entrée et le deuxième signal numérique sur une seconde entrée, un multiplieur agencé pour multiplier un signal complexe délivré en sortie du premier module de transformée de Fourier avec un signal complexe délivré en sortie du second module de transformée de Fourier, et un module de transformée de Fourier inverse agencé pour recevoir le signal complexe délivré en sortie du multiplieur et fournir en sortie le premier réflectogramme sur une voie réelle et le second réflectogramme sur une voie imaginaire.

Selon un mode de réalisation particulier de l'invention, ledit groupe de lignes de transmission comprend deux lignes de transmission, ledit système comprenant deux convertisseurs analogique-numérique, le premier signal numérique et le second signal numérique correspondant aux deux lignes de transmission respectives.

Selon un autre mode de réalisation particulier de l'invention, ledit groupe de lignes de transmission comprend une unique ligne, ledit système comprenant un unique convertisseur analogique-numérique, un dispositif pour décomposer un signal en plusieurs signaux, à une entrée et un nombre N de sorties pair, configuré pour recevoir le signal numérique converti et pour délivrer, sur chaque sortie, une version sous-échantillonnée du signal d'entrée d'un facteur N, et un multiplexeur, à N entrées et une sortie, dont chaque entrée est reliée à une sortie respective d'un corrélateur complexe, le multiplexeur étant configuré pour produire en sortie un unique réflectogramme à partir d'au moins le premier réflectogramme et le deuxième réflectogramme, ledit système comprenant un nombre N/2 de corrélateurs complexes.

Selon un autre mode de réalisation particulier de l'invention, le dispositif pour décomposer un signal en plusieurs signaux est configuré pour transmettre chaque nouvel échantillon reçu en entrée vers une nouvelle sortie d'indice incrémenté de un modulo N, et le multiplexeur est configuré pour délivrer en sortie, à chaque nouvel instant, un nouvel échantillon reçu sur une nouvelle entrée d'indice incrémenté de un modulo N à chaque nouvel instant.

Selon un aspect particulier de l'invention, la fréquence d'échantillonnage du convertisseur analogique numérique est sensiblement égale à N fois la fréquence d'échantillonnage du signal injecté dans la ligne et la fréquence de traitement du ou des corrélateur(s) complexe(s) est supérieure ou égale à la fréquence d'échantillonnage du signal injecté dans la ligne et strictement inférieure à la fréquence d'échantillonnage du convertisseur analogique-numérique

Selon un aspect particulier de l'invention, le dispositif pour décomposer un signal en plusieurs signaux est configuré pour, transmettre chaque nouveau bloc d'échantillons reçus en entrée vers une nouvelle sortie d'indice incrémenté de un modulo N et le multiplexeur est configuré pour délivrer en sortie, à chaque nouvel instant, un nouveau bloc d'échantillons reçus sur une nouvelle entrée d'indice incrémenté de un modulo N à chaque nouvel instant, le système comprenant en outre un nombre N de mémoires FIFO d'entrée étant chacune connectée entre une sortie distincte du dispositif pour décomposer un signal en plusieurs signaux et une entrée distincte d'un corrélateur complexe distinct, le système comprenant aussi un nombre N de mémoires FIFO de sortie étant chacune connectée entre une sortie distincte d'un corrélateur complexe distinct et une entrée distincte du multiplexeur.

Selon un aspect particulier de l'invention, le signal de référence est périodique et le nombre d'échantillons par bloc est égal au nombre d'échantillons par période du signal de référence.

Selon un aspect particulier de l'invention, la fréquence d'échantillonnage du convertisseur analogique-numérique est sensiblement égale à la fréquence d'échantillonnage du signal injecté dans la ligne et la fréquence de traitement du ou des corrélateur(s) complexe(s) est au moins égale à la fréquence d'échantillonnage du convertisseur analogique-numérique divisée par N et strictement inférieure à la fréquence d'échantillonnage du convertisseur analogique-numérique, divisée par N-2 si N est différent de deux.

Selon une variante particulière, le système de réflectométrie selon l'invention comprend un générateur du signal de référence, au moins un convertisseur numérique-analogique et au moins un dispositif d'injection pour injecter le signal de référence analogique dans chaque ligne de transmission dudit groupe.

D'autres caractéristiques et avantages de la présente invention apparaîtront mieux à la lecture de la description qui suit en relation aux dessins annexés qui représentent :

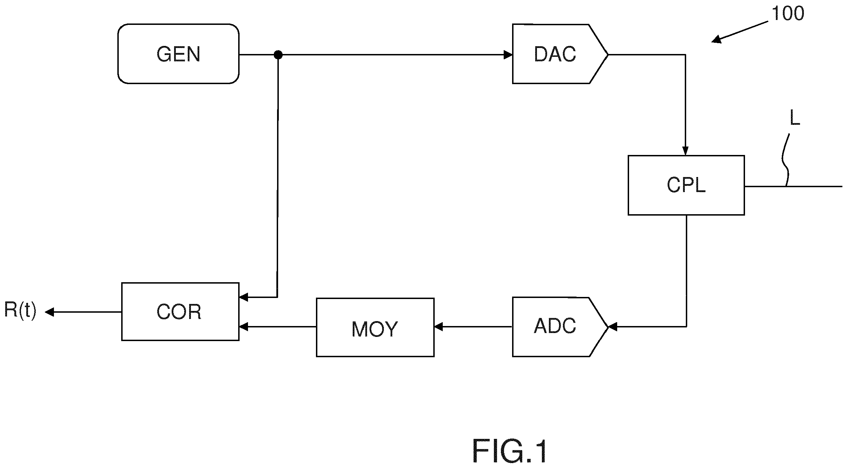

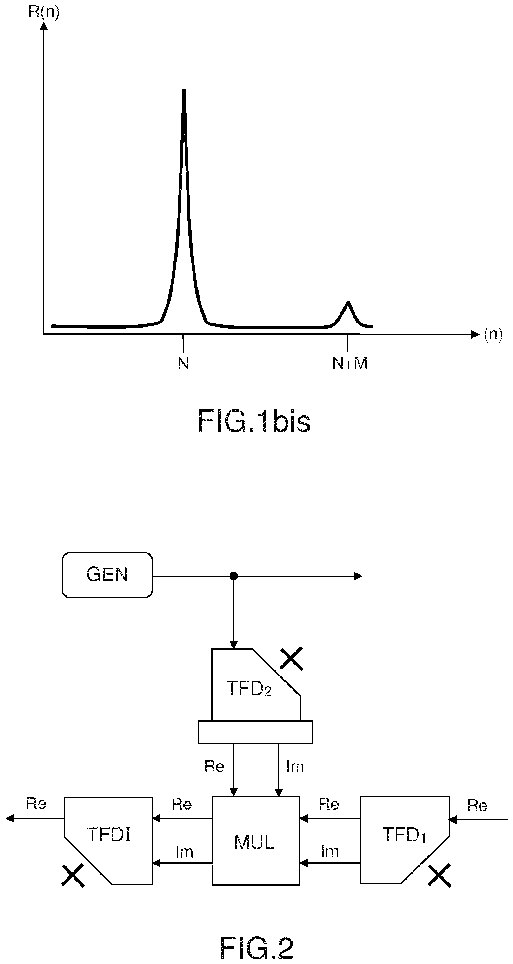

- La figure 1, un schéma d'un système de réflectométrie selon l'art antérieur,
- La figure 1bis, un exemple de réflectogramme obtenu avec le système de réflectométrie de la figure 1,
- La figure 2, un schéma d'un corrélateur utilisé dans un système de réflectométrie du type décrit à la figure 1,
- La figure 3, un schéma d'un corrélateur utilisé dans un système de réflectométrie modifié selon l'invention,
- La figure 4, un schéma d'un système de réflectométrie selon un premier mode de réalisation de l'invention,
- La figure 5a, un schéma d'un système de réflectométrie selon un deuxième mode de réalisation de l'invention,
- La figure 5b, une variante du système selon le deuxième mode de réalisation de l'invention,
- La figure 6a, un schéma d'un système de réflectométrie selon un troisième mode de réalisation de l'invention,
- La figure 6b, une variante du système selon le troisième mode de réalisation de l'invention.

La figure 1 représente un schéma d'un système 100 d'analyse de défaut dans une ligne de transmission L, telle qu'un câble, selon une méthode usuelle de réflectométrie temporelle de l'état de l'art. Un tel système comprend principalement un générateur GEN d'un signal de référence. Le signal de référence numérique généré est converti analogiquement via un convertisseur numérique-analogique DAC puis est injecté en un point de la ligne de transmission L au moyen d'un coupleur directionnel CPL ou tout autre dispositif permettant d'injecter un signal dans une ligne. Le signal se propage le long de la ligne et se réfléchit sur les singularités qu'elle comporte. En l'absence de défaut sur la ligne, le signal se réfléchit sur l'extrémité de la ligne si la terminaison de la ligne est non adaptée. En présence de défaut sur la ligne, le signal se réfléchit sur la discontinuité d'impédance provoquée par le défaut. Le signal réfléchi est rétro-propagé jusqu'à un point de mesure, qui peut être commun au point d'injection ou différent. Le signal rétro-propagé est mesuré via le coupleur directionnel CPL puis converti numériquement par un convertisseur analogique numérique ADC. Une corrélation COR est ensuite effectuée entre le signal numérique mesuré et une copie du signal numérique généré avant injection afin de produire un réflectogramme temporel R(t) correspondant à l'inter-corrélation entre les deux signaux.

Comme cela est connu dans le domaine des méthodes de diagnostic par réflectométrie temporelle, la position $d_{DF}$ d'un défaut sur le câble L, autrement dit sa distance au point d'injection du signal, peut être directement obtenue à partir de la mesure, sur le réflectogramme temporel calculé R(t), de la durée $t_{DF}$ entre le premier pic d'amplitude relevé sur le réflectogramme et le pic d'amplitude correspondant à la signature du défaut.

La figure 1bis représente un exemple de réflectogramme R(n) obtenu à l'aide du système de la figure 1, sur lequel on observe un premier pic d'amplitude à une abscisse N et un second pic d'amplitude à une abscisse N+M. Le premier pic d'amplitude correspond à la réflexion du signal au point d'injection dans le câble, tandis que le second pic correspond à la réflexion du signal sur une discontinuité d'impédance provoquée par un défaut

Différentes méthodes connues sont envisageables pour déterminer la position $d_{DF}$. Une première méthode consiste à appliquer la relation liant distance et temps : $d_{DF} = V_g \cdot t_{DF}/2$ où $V_g$ est la vitesse de propagation du signal dans le câble. Une autre méthode possible consiste à appliquer une relation de proportionnalité du type $d_{DF}/t_{DF} = L_c/t_0$ où $L_c$ est la longueur du câble et $t_0$ est la durée, mesurée sur le réflectogramme, entre le pic d'amplitude correspondant à la discontinuité d'impédance au point d'injection et le pic d'amplitude correspondant à la réflexion du signal sur l'extrémité du câble. Afin de diminuer le niveau du bruit de mesure, un calcul de moyenne MOY optionnel peut être réalisé avant ou après la corrélation COR. Les deux emplacements du calcul de moyenne sont équivalents d'un point de vue arithmétique.

Un dispositif d'analyse (non représenté à la figure 1) est chargé d'analyser le réflectogramme R(t) pour en déduire des informations de présence et/ou localisation de défauts ainsi que les caractéristiques électriques éventuelles des défauts.

Sans sortir du cadre de l'invention, les parties émission et réception du système décrit à la figure 1 peuvent être implémentées dans un même dispositif ou dans deux dispositifs distincts. La partie émission du système comprend le générateur de signal, le convertisseur numérique-analogique et le dispositif d'injection du signal dans un câble. La partie réception du système comprend le dispositif de mesure du signal rétro-propagé dans le câble et les modules de calcul numériques comprenant le calcul de moyenne et d'inter-corrélation.

Le corrélateur COR d'un système de réflectométrie peut avantageusement être implémenté sous la forme décrite à la figure 2. Selon cette implémentation possible, le corrélateur COR comprend un premier module de transformée de Fourier discrète $TFD_1$ du signal mesuré, un second module de transformée de Fourier discrète $TFD_2$ du signal de référence, un multiplieur MUL pour calculer le produit des deux résultats précédents puis enfin un module de transformée de Fourier discrète inverse TFDI appliqué au résultat du produit. Cette implémentation résulte de la formule suivante exprimant l'inter-corrélation de deux signaux x(t) et x'(t) :

$$c(t) = \int_{-\infty}^{\infty} x'(t+\tau) \cdot x^*(\tau) \mathrm{d}\tau = \mathsf{TF}^{-1}\left\{\mathsf{TF}\left\{x'(t)\right\} \cdot \mathsf{TF}\left\{x^*(t)\right\}\right\}$$

, TF désigne l'opération de transformée de Fourier, tandis que TF$^{-1}$ désigne l'opération de transformée de Fourier inverse.

Cette relation découle du fait que l'opération de corrélation dans le domaine temporel correspond à une opération de multiplication dans le domaine fréquentiel.

Les modules de transformée de Fourier et transformée de Fourier inverse comprennent chacun deux entrées et deux sorties correspondant respectivement aux parties réelle et imaginaire d'un signal complexe.

Selon l'implémentation décrite à la figure 2, le signal numérisé en sortie du convertisseur analogique-numérique ADC est produit sur l'entrée réelle du premier module de transformée de Fourier discrète $TFD_1$ et le signal de référence est produit sur l'entrée réelle du second module de transformée de Fourier discrète $TFD_2$. Le résultat R(t) de l'inter-corrélation entre les deux signaux est disponible sur la sortie réelle du module de transformée de Fourier discrète inverse TFDI. L'expression « entrée/sortie réelle » est employée ici pour désigner la première entrée/sortie parmi les deux entrées/sorties disponibles, la seconde entrée/sortie étant appelée « entrée/sortie imaginaire».

L'invention se base sur la propriété mathématique décrite ci-après du corrélateur décrit à la figure 2. Notons r(t) le signal de référence généré et $s_1(t)$ et $s_2(t)$ deux signaux distincts produits respectivement sur l'entrée réelle et l'entrée complexe du premier module de transformée de Fourier discrète $TFD_1$ du corrélateur COR. Notons, $\Gamma_{rs1}(t)$ et $\Gamma_{rs2}(t)$ les résultats respectifs de l'inter-corrélation entre r(t) et $s_1(t)$ d'une part et entre r(t) et $s_2(t)$ d'autre part.

L'opération de corrélation dans le domaine temporel correspond à un produit dans le domaine fréquentiel. On dérive ainsi les équivalences suivantes :

$$\mathbf{\Gamma_{rs1}(t)} = \int_T \mathbf{r}(\tau) \cdot \mathbf{s}_1^*(t+\tau)\, \mathbf{d\tau} \quad \Leftrightarrow \quad \mathbf{\Gamma_{RS1}(f)} = \mathbf{R(f)} \cdot \mathbf{S_1(f)}$$

$$\mathbf{\Gamma_{rs2}(t)} = \int_T \mathbf{r}(\tau) \cdot \mathbf{s}_2^*(t+\tau)\, \mathbf{d\tau} \quad \Leftrightarrow \quad \mathbf{\Gamma_{RS2}(f)} = \mathbf{R(f)} \cdot \mathbf{S_2(f)}$$

R(f) est le résultat de la transformée de Fourier appliquée à r(t),
$s_1(f)$ est le résultat de la transformée de Fourier appliquée à $s_1(t)$,
$s_2(f)$ est le résultat de la transformée de Fourier appliquée à $s_2(t)$,
$\Gamma_{RS1}(f)$ est le résultat de la transformée de Fourier appliquée à $\Gamma_{rs1}(t)$,
$\Gamma_{RS2}(f)$ est le résultat de la transformée de Fourier appliquée à $\Gamma_{rs2}(t)$.

Ainsi, en transmettant les deux signaux $s_1(t)$ et $s_2(t)$ sur les deux entrées du premier module de transformée de Fourier discrète $TFD_1$ du corrélateur COR, on obtient en sortie du corrélateur une valeur complexe donnée par la relation suivante :

$$\Gamma_{rs}(t) = \Gamma_{rs1}(t) + j \cdot \Gamma_{rs2}(t) = \int_T r(\tau) \cdot (s_1^* + j \cdot s_2^*)(t+\tau)\, d\tau$$

$$= \int_T r(\tau) \cdot s_1^*(t+\tau)\, d\tau + j \cdot \int_T r(\tau) \cdot s_2^*(t+\tau)\, d\tau$$

$$= TF^{-1}\left\{ R(f) \cdot (S_1(f) + j \cdot S_2(f)) \right\}$$
$$= TF^{-1}\left\{ TF\left\{ r(t) \right\} \cdot TF\left\{ s_1(t) + j \cdot s_2(t) \right\} \right\}$$
$$= r(t) \star s_1(t) + j \cdot r(t) \star s_2(t)$$

Ainsi, on voit bien que les sorties réelle et imaginaire du corrélateur COR de la figure 2 permettent de délivrer deux résultats de corrélation indépendants correspondants respectivement à l'inter-corrélation entre le signal de référence (réel) et un premier signal reçu sur la voie réelle du premier module de transformée de Fourier discrète $TFD_1$ et l'intercorrélation entre le signal de référence (réel) et un second signal reçu sur la voie imaginaire du premier module de transformée de Fourier discrète TFD$_1$.

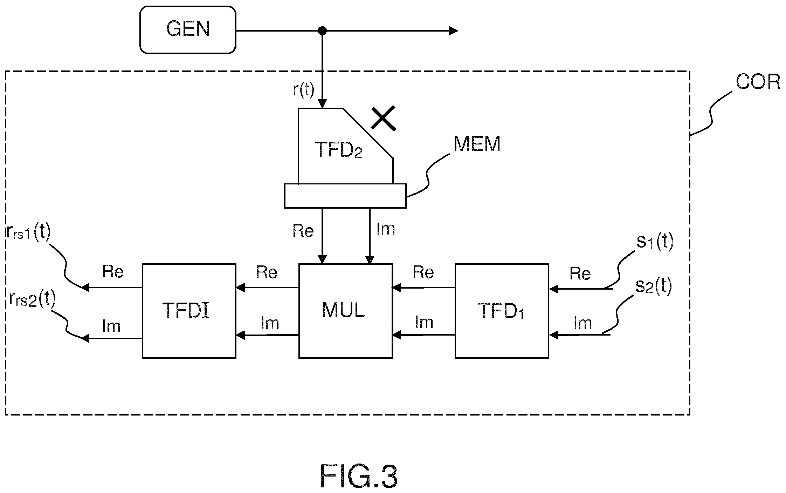

Ce principe est illustré à la figure 3 sur laquelle est représenté le même corrélateur COR qu'à la figure 2 mais cette fois, les deux entrées du premier module de transformée de Fourier discrète TFD$_1$ sont alimentées par deux signaux distincts et deux résultats d'inter-corrélation indépendants, associés aux deux signaux distincts, sont fournis sur les deux sorties du module de transformée de Fourier discrète inverse TFDI. Il convient de noter que le calcul de transformée de Fourier discrète TFD$_2$ appliqué au signal de référence peut n'être exécuté qu'une seule fois, initialement, le résultat du calcul étant stocké dans une mémoire MEM pour être ensuite utilisé pour plusieurs acquisitions successives du signal mesuré.

L'invention est basée sur le principe décrit ci-dessus et utilise un corrélateur configuré selon la description faite à la figure 3 pour augmenter les capacités d'un système de réflectométrie. Sans sortir du cadre de l'invention, le corrélateur COR peut être mis en œuvre au moyen d'une implémentation différente, l'indépendance des résultats de corrélation sur les deux voies de sortie du corrélateur existant quelle que soit l'implémentation.

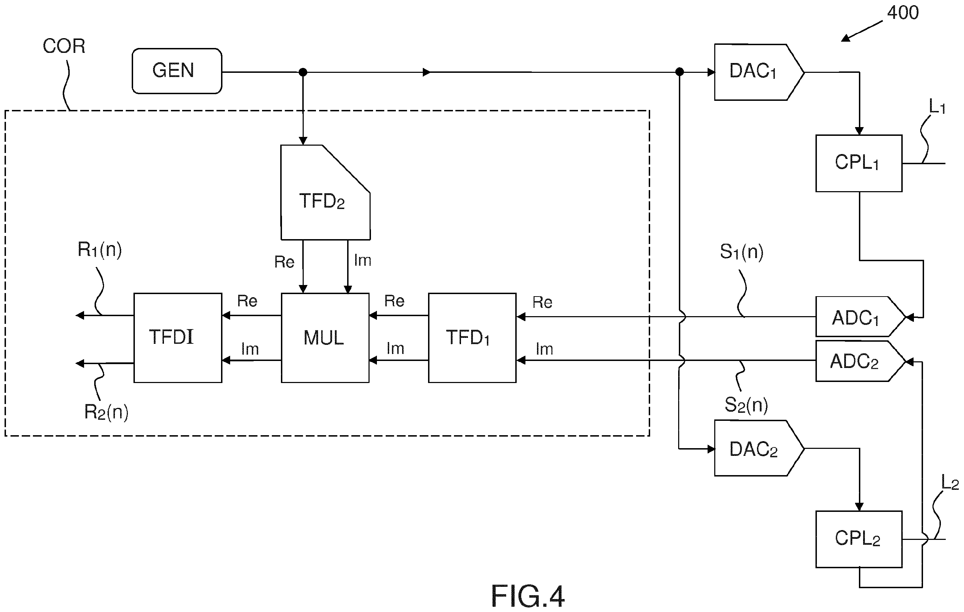

La figure 4 représente un système de réflectométrie 400 selon un premier mode de réalisation de l'invention.

Le système 400 est adapté pour réaliser, à partir d'un seul équipement, une analyse de défauts sur deux lignes de transmission L$_1$,L$_2$ distinctes. Ces deux lignes appartiennent, par exemple et comme indiqué précédemment, à une liasse comprenant plusieurs lignes ou câbles.

Le système 400 comprend un générateur de signal de référence numérique GEN, deux convertisseurs numérique-analogique DAC$_1$,DAC$_2$ et deux coupleurs directifs CPL$_1$,CPL$_2$ pour injecter le signal de référence dans les deux lignes de transmission L$_1$,L$_2$. Alternativement, un unique convertisseur numérique-analogique peut être utilisé et être associé à un dispositif permettant de relayer le signal analogique respectivement vers les deux coupleurs directifs CPL$_1$,CPL$_2$.

Le système 400 comprend également deux convertisseurs analogique-numérique ADC$_1$,ADC$_2$ qui reçoivent chacun les signaux respectivement mesurés sur les deux lignes de transmission. Les moyens de mesure peuvent être réalisés par un coupleur directif ou par tout autre dispositif permettent de prélever le signal rétro-propagé en un point d'une ligne.

Les deux signaux numériques s$_1$(n), s$_2$(n) obtenus en sortie des deux convertisseurs analogique-numérique ADC$_1$,ADC$_2$ sont ensuite produits sur les deux voies d'entrées du corrélateur COR. Les deux voies de sortie du corrélateur COR produisent deux réflectogrammes R$_1$(n) et R$_2$(n) qui correspondent respectivement aux deux lignes de transmission L$_1$,L$_2$. Comme expliqué ci-dessus, le corrélateur COR permet ainsi de traiter deux signaux en parallèle, ce qui présente l'avantage de pouvoir analyser simultanément deux lignes de transmission d'un même groupe de lignes, ce qui procure un gain en temps de traitement d'un facteur deux.

Le premier convertisseur numérique-analogique DAC$_1$ et le second convertisseur numérique-analogique DAC$_2$ peuvent être synchronisés ou non. En particulier, il peut exister un décalage temporel entre les deux convertisseurs. La même considération s'applique aux deux convertisseurs analogique-numérique ADC$_1$,ADC$_2$.

Le système 400 décrit à la figure 4 permet d'analyser la présence de défauts sur deux câbles en parallèle et de pouvoir détecter des défauts qui impactent les deux câbles simultanément au même endroit. Le gain de temps de traitement est important car le nombre de câbles à tester au sein d'un même emplacement peut être très important, typiquement de l'ordre de plusieurs dizaines de câbles.

Par ailleurs, le système 400 permet aussi de connaitre l'effet du couplage entre deux lignes adjacentes quand l'une des deux est affectée par un défaut, en particulier par un défaut intermittent.

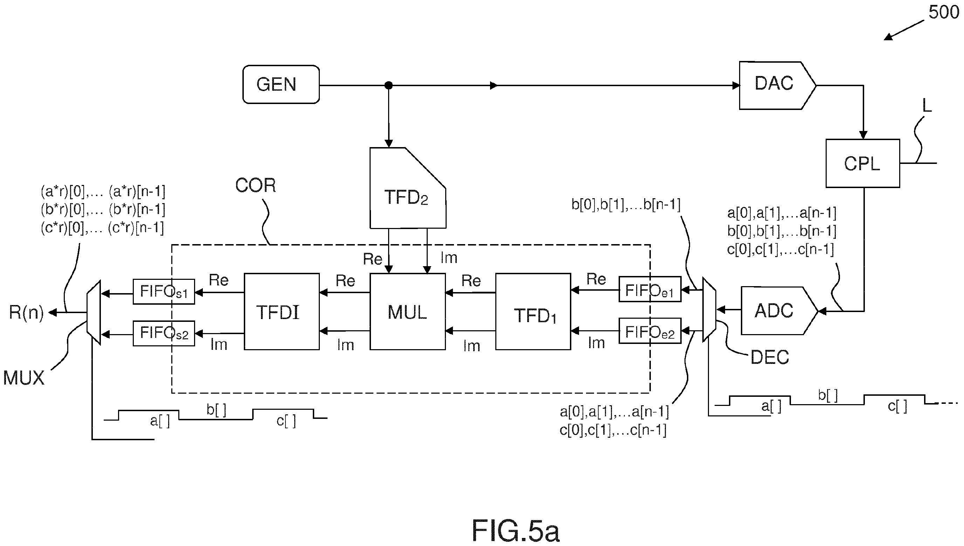

La figure 5a représente un schéma d'un système de réflectométrie 500 selon un deuxième mode de réalisation de l'invention.

Le système 500 est adapté pour analyser les défauts présents sur une unique ligne de transmission L. Il comporte les mêmes composants déjà introduits pour le système décrit à la figure 1. Dans ce deuxième mode de réalisation, on considère un cas d'application pour lequel le corrélateur COR est implémenté sur un processeur ou un circuit ayant une fréquence de traitement F$_{cor}$ inférieure à la fréquence d'échantillonnage Fe du convertisseur analogique-numérique ADC. Dans ce cas d'application, on considère que le convertisseur numérique-analogique DAC et le convertisseur analogique-numérique ADC fonctionnent à la même fréquence d'échantillonnage. La fréquence de traitement désigne ici la fréquence à laquelle le composant qui réalise la fonction de corrélation est capable de traiter les échantillons de signal numérique reçus en entrée et provenant du convertisseur analogique-numérique ADC. Il peut s'agir de la fréquence d'horloge du composant. Par exemple, la fréquence de traitement F$_{cor}$ est au moins égale à Fe/2 et strictement inférieure à Fe. Il convient de noter que le système 500 peut fonctionner également si la fréquence de traitement F$_{cor}$ est supérieure ou égale à la fréquence d'échantillonnage Fe, cependant un tel cas de figure présente peu d'intérêt car dans ce cas, le signal de sortie du convertisseur analogique-numérique ADC peut être traité par une seule voie du corrélateur COR.

Dans ce cas, le système décrit à la figure 1 ne permet pas de calculer la corrélation au même rythme que le rythme d'arrivée des échantillons.

Pour pallier ce problème, le système 500 utilise les deux voies d'entrée du corrélateur COR pour pouvoir réaliser le calcul de corrélation au même rythme que le rythme d'arrivée des échantillons.

Pour cela, le système 500 comporte en outre un dispositif DEC pour décomposer le signal fourni en sortie du convertisseur analogique-numérique ADC en deux signaux distincts produits sur les deux entrées du corrélateur COR. Il comporte également deux mémoires FIFO d'entrée $FIFO_{e1}$,$FIFO_{e2}$ et deux mémoires FIFO de sortie $FIFO_{s1}$,$FIFO_{s2}$. Il comporte aussi un multiplexeur MUX.

Le dispositif DEC peut être réalisé au moyen d'un commutateur, d'un démultiplexeur ou de tout composant équivalent qui permet d'aiguiller les échantillons du signal reçu à son entrée vers l'une de ses deux sorties.

Le signal généré par le générateur GEN est un signal périodique. Si on note n le nombre d'échantillons de signal par période, alors le dispositif DEC est configuré pour transmettre alternativement chaque bloc successif de n échantillons reçus sur son entrée vers l'une des deux sorties. Par exemple, comme indiqué sur la figure 5a pour les trois premiers blocs d'échantillons de taille n reçus a,b,c, le premier bloc a est envoyé sur la seconde sortie, le deuxième bloc b est envoyé sur la première sortie puis le troisième bloc c est envoyé à nouveau sur la seconde sortie et ainsi de suite. Les échantillons sont transmis successivement vers les mémoires FIFO d'entrée qui stockent les blocs de n échantillons avant de les transmettre sur chaque voie d'entrée respective du corrélateur COR. De cette façon, le calcul de corrélation est réalisé sur des périodes cohérentes du signal mesuré.

Le dispositif DEC est piloté par un signal de contrôle synchrone de la durée des blocs d'échantillons de taille n.

En sortie du corrélateur COR, les échantillons sont transmis également dans des mémoires FIFO de sortie $FIFO_{s1}$,$FIFO_{s2}$ pour stocker des blocs de n échantillons qui sont ensuite multiplexés, au moyen d'un multiplexeur MUX, en un unique signal recomposé qui correspond au réflectogramme du signal mesuré sur la ligne L, sur plusieurs périodes. Le multiplexeur MUX peut être remplacé par tout composant équivalent permettant de recomposer un signal unique à partir de deux signaux reçus sur deux voies d'entrée. Le multiplexeur MUX aiguille successivement vers sa sortie, et alternativement, un bloc de n échantillons présent dans chacune des deux mémoires FIFO de sortie. Autrement dit, lorsqu'un bloc de n échantillons est disponible dans la première mémoire FIFO de sortie $FIFO_{s1}$, ce bloc est transmis vers la sortie, puis le bloc suivant est prélevé dans la seconde mémoire FIFO de sortie $FIFO_{s2}$, puis le bloc suivant est à nouveau prélevé dans la première mémoire FIFO de sortie $FIFO_{s1}$, et ainsi de suite.

Le multiplexeur MUX est piloté par un signal de sélection synchrone de la durée des blocs d'échantillons de taille n.

Une mémoire FIFO d'entrée ou de sortie est dimensionnée pour permettre un fonctionnement en continu du système.

Le système 500 selon le second mode de réalisation de l'invention permet ainsi une accélération du calcul de corrélation en parallélisant les calculs grâce aux deux entrées du corrélateur complexe. Ainsi, il est possible de réaliser le calcul de corrélation à un débit compatible de celui du convertisseur analogique-numérique. Cela présente un avantage considérable par rapport au système 100 décrit à la figure 1 lorsque la fréquence de traitement du composant réalisant le corrélateur COR est strictement inférieure à la fréquence d'échantillonnage du convertisseur analogique-numérique. Ce cas de figure est courant car les convertisseurs sont des composants mixtes qui peuvent fonctionner à des fréquences élevées en utilisant des technologies spécifiques contrairement aux composants destinés à réaliser des fonctions logiques tels qu'un processeur de signal ou un circuit numérique de type FPGA ou ASIC.

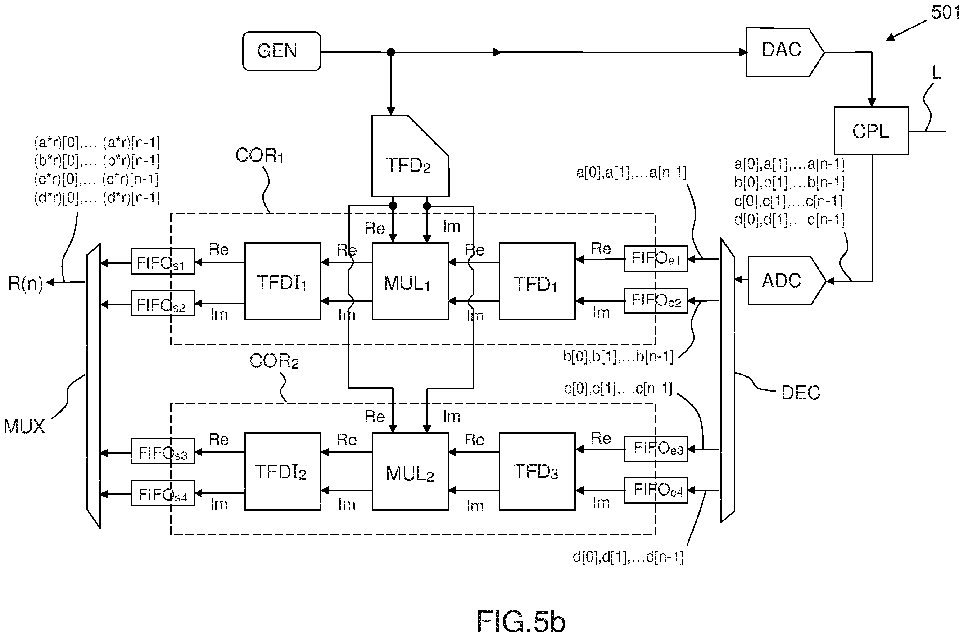

La figure 5b représente une variante du deuxième mode de réalisation du système selon l'invention.

Le système 500 décrit à la figure 5a peut être aisément étendu pour des cas d'application où la fréquence de traitement $F_{cor}$ du composant qui réalise la corrélation est strictement inférieure à Fe/2, où Fe est la fréquence d'échantillonnage du convertisseur analogique-numérique ADC. Dans ce cas, le système selon l'invention est modifié et comprend deux corrélateurs $COR_1$ et $COR_2$ qui fonctionnent en parallèle. Le système 501 de la figure 5b comprend alors quatre mémoires FIFO d'entrée $FIFO_{e1}$, $FIFO_{e2}$, $FIFO_{e3}$,$FIFO_{e4}$ et quatre mémoires FIFO de sortie $FIFO_{s1}$,$FIFO_{s2}$, $FIFO_{s3}$,$FIFO_{s4}$. Le dispositif de décomposition DEC du signal d'entrée est cette fois configuré pour aiguiller chaque nouveau bloc de n échantillons reçus vers une nouvelle sortie successive parmi les quatre sorties du dispositif DEC. Sur l'exemple de la figure 5b, on a représenté le fonctionnement du dispositif DEC pour les quatre premiers blocs a,b,c,d du signal reçu, chaque bloc étant aiguillé vers une sortie respective, ce processus étant itéré pour tous les blocs de n échantillons du signal reçu. De même, le multiplexeur MUX comporte quatre entrées et est configuré pour recomposer un unique signal en aiguillant successivement chaque bloc de n échantillons disponibles dans chaque mémoire FIFO de sortie vers la sortie du multiplexeur. Ainsi, sur chaque voie de corrélation, la fréquence d'arrivée des échantillons est égale à Fe/4.

On peut généraliser l'exemple décrit à la figure 5b à un nombre quelconque de corrélateurs égal à N/2, avec N un nombre entier pair, strictement positif.

Si le système comprend N/2 corrélateurs COR, il comprend N mémoires FIFO d'entrée et N mémoires FIFO de sortie, un dispositif de décomposition du signal d'entrée à une entrée et N sorties et un multiplexeur à N entrées et une sortie.

Un tel système est adapté si le ou les composants réalisant les calculs de corrélation fonctionnent à une fréquence de traitement $F_{cor}$ qui est au moins égale à Fe/N et strictement inférieure à Fe/(N-2): $Fe/N \le F_{cor} < Fe/(N-2)$.

En effet, un corrélateur doit fonctionner à une fréquence de traitement au moins égale à Fe/N qui est la fréquence d'arrivée des échantillons sur chaque sortie du dispositif de décomposition DEC. Si il fonctionne à une fréquence supérieure ou égale à Fe/(N-2), alors on peut supprimer un corrélateur, car N/2-1 corrélateurs suffisent à pouvoir traiter les échantillons reçus à une fréquence de traitement compatible de la fréquence d'échantillonnage du convertisseur analogique-numérique.

Si un seul corrélateur est utilisé, c'est-à-dire si N=2 (cas de la figure 5a), alors la fréquence de traitement du corrélateur respecte la relation $Fe/2 \leq F_{cor} < Fe$.

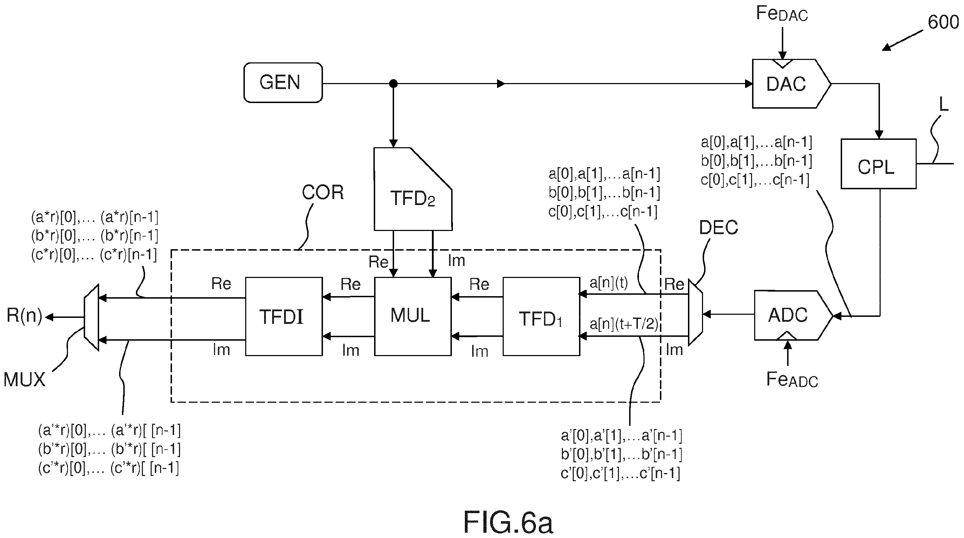

La figure 6a représente un schéma d'un système de réflectométrie 600 selon un troisième mode de réalisation de l'invention.

Le système 600 est adapté pour analyser les défauts présents sur une unique ligne de transmission L. Il comporte les mêmes composants déjà introduits pour le système décrit à la figure 1.

Ce troisième mode de réalisation est adapté à un cas d'application pour lequel la fréquence d'échantillonnage $Fe_{ADC}$ du convertisseur analogique-numérique ADC est strictement supérieure à la fréquence d'échantillonnage $Fe_{DAC}$ du convertisseur numérique-analogique DAC, le rapport $Fe_{ADC}/Fe_{DAC}$ étant égal à un nombre entier M strictement supérieur à 1. La fréquence de traitement du composant qui réalise la corrélation COR est égale à la fréquence d'échantillonnage $Fe_{DAC}$ du convertisseur numérique-analogique DAC.

Le système 600 comporte un dispositif DEC pour décomposer le signal en sortie du convertisseur analogique-numérique ADC en deux signaux distincts et un multiplexeur MUX pour recomposer un unique signal à partir des deux signaux produits sur les deux sorties du corrélateur COR. Le dispositif DEC est relié par ses deux sorties aux deux entrées du corrélateur COR. Le multiplexeur MUX est relié par ses deux entrées aux deux sorties du corrélateur COR. Le dispositif DEC est piloté par un signal de contrôle à la fréquence $Fe_{ADC}$. Le multiplexeur MUX est piloté par un signal de sélection à la fréquence $Fe_{ADC}$.

Dans l'exemple de la figure 6a, le rapport $Fe_{ADC}/Fe_{DAC}$ est égal à deux. Ainsi, le convertisseur analogique-numérique ADC sur-échantillonne le signal d'un facteur deux par rapport au signal numérique généré par le générateur GEN.

Le dispositif DEC distribue un échantillon reçu sur son entrée alternativement sur l'une puis l'autre de ses sorties. Ainsi, sur chacune des deux sorties du dispositif DEC, on retrouve un signal à une fréquence d'échantillonnage égale à celle du convertisseur numérique-analogique. Chacun des deux signaux est décalé temporellement de T/2 avec $T=1/Fe_{DAC}$, la période d'échantillonnage du signal généré.

Le corrélateur COR calcule l'inter-corrélation de chacun des deux signaux avec une copie du signal de référence généré. Sur chacune des deux sorties du corrélateur COR, on retrouve un résultat d'inter-corrélation qui correspond à un réflectogramme du signal à la fréquence d'échantillonnage $FE_{DAC}$ mais avec un décalage temporel de T/2.

Le multiplexeur MUX est configuré pour multiplexer les deux réflectogrammes afin de produire un réflectogramme unique R(n) qui correspond à l'entrelacement des deux réflectogrammes obtenus en sortie de corrélateur COR. Le réflectogramme unique R(n) ainsi obtenu présente une résolution temporelle supérieure à celle d'un réflectogramme calculé à partir d'un seul signal à la fréquence d'échantillonnage $Fe_{DAC}$. Il comporte un échantillon sur deux provenant du signal reçu sur la première entrée du multiplexeur MUX et un échantillon sur deux provenant du signal reçu sur la seconde entrée du multiplexeur MUX. Ainsi, le système 600 permet d'améliorer la précision de détection et de localisation d'un défaut apparaissant sur la ligne L car l'augmentation de la résolution temporelle du réflectogramme entraîne directement une augmentation de la résolution spatiale pour la localisation de défaut le long de la ligne L. Ainsi, des défauts de faible taille, peuvent être mieux détectés et localisés.

Ces avantages sont obtenus grâce à l'utilisation des deux voies du corrélateur COR. En effet, avec le système décrit à la figure 1, même si la fréquence d'échantillonnage $Fe_{ADC}$ du convertisseur analogique-numérique est plus élevée que celle du convertisseur numérique-analogique, le corrélateur ne peut pas calculer l'inter-corrélation au rythme d'arrivée du signal sur-échantillonné d'un facteur deux.

Le système 600 peut être avantageusement mis en œuvre lorsque la fréquence de traitement du corrélateur COR est au moins égale à la fréquence d'échantillonnage $Fe_{DAC}$ du signal généré et strictement inférieure à la fréquence d'échantillonnage $Fe_{ADC}$ du convertisseur analogique-numérique ADC et que le ratio $Fe_{ADC}/Fe_{DAC}$ est égal à 2.

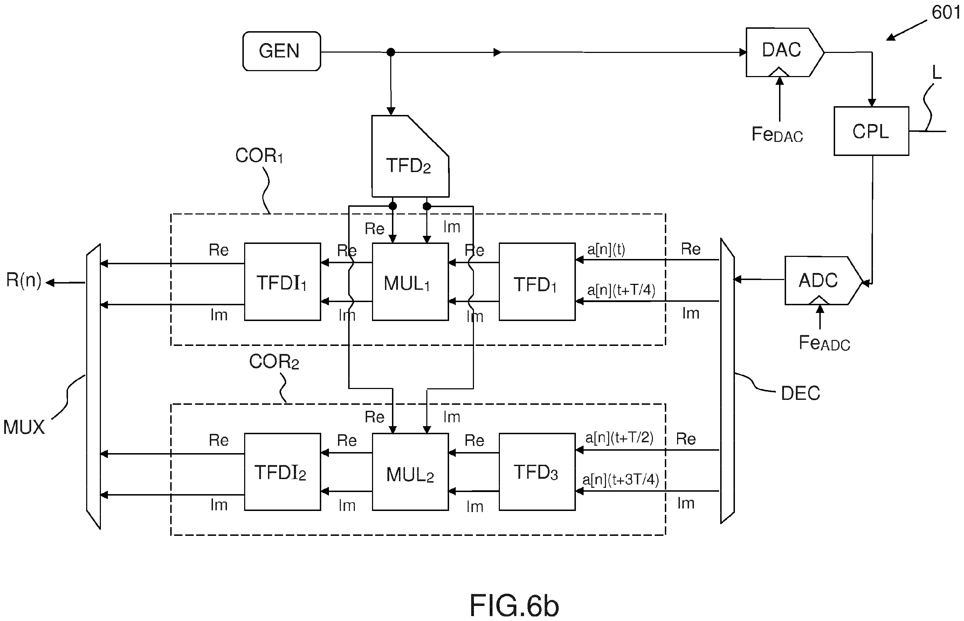

La figure 6b décrit une variante du troisième mode de réalisation de l'invention pour lequel le rapport $Fe_{ADC}/Fe_{DAC}$ est égal à 4 et la fréquence de traitement d'un corrélateur $F_{COR}$ est toujours égale à la fréquence d'échantillonnage $Fe_{DAC}$ du signal généré.

Dans ce cas de figure, le système 601 selon l'invention comprend deux corrélateurs $COR_1, COR_2$. Le dispositif DEC de décomposition du signal de sortie du convertisseur ADC comprend une entrée et quatre sorties et est configuré pour aiguiller successivement chaque échantillon de signal reçu sur son entrée vers une sortie successive. Autrement dit, le premier échantillon a[n](t) est transmis vers la première sortie, le deuxième échantillon a[n](t+T/4) est transmis vers la deuxième sortie, le troisième échantillon a[n](t+T/2) est transmis vers la troisième sortie, le quatrième échantillon a[n](t+3T/4) est transmis vers la quatrième sortie. Cette séquence étant itérée ainsi de suite. Autrement dit, sur chaque sortie du dispositif DEC, on retrouve un signal à la fréquence d'échantillonnage $Fe_{DAC}$ décalé de T/4 par rapport au signal sur la sortie suivante.

Les deux premières sorties du dispositif DEC sont reliées aux deux entrées d'un premier corrélateur $COR_1$. Les deux dernières sorties du dispositif DEC sont reliées aux deux entrées d'un second corrélateur $COR_2$.

Le multiplexeur MUX comprend quatre entrées et une sortie. Ses deux premières entrées sont reliées aux deux sorties du premier corrélateur $COR_1$ et ses deux autres entrées sont reliées aux deux sorties du second corrélateur $COR_2$.

Le multiplexeur MUX est configuré pour entrelacer les quatre signaux reçus afin de former un unique réflectogramme R(n) dont la résolution temporelle est quatre fois supérieure à celle obtenue avec le système de la figure 1 fonctionnant dans les mêmes conditions de fréquences de fonctionnement.

Le système 601 peut être avantageusement mis en œuvre lorsque la fréquence de traitement du composant réalisant les corrélateurs $COR_1, COR_2$ est au moins égale à la fréquence d'échantillonnage $Fe_{DAC}$ du signal généré et strictement inférieure à la fréquence d'échantillonnage $Fe_{ADC}$ du convertisseur analogique-numérique ADC et que le ratio $Fe_{ADC}/ Fe_{DAC}$ est égal à 4.

Il est possible de généraliser le système 601 pour des cas d'application où la fréquence de traitement du composant réalisant les corrélateurs est au moins égale à la fréquence d'échantillonnage $Fe_{DAC}$ du signal généré et strictement inférieure à la fréquence d'échantillonnage $Fe_{ADC}$ du convertisseur analogique-numérique ADC et le ratio $Fe_{ADC}/ Fe_{DAC}$ est égal à N, avec N un nombre entier, pair, au moins égal à 2.

Dans ce cas, le système selon le troisième mode de réalisation de l'invention comporte N/2 corrélateurs fonctionnant en parallèle. Le dispositif DEC de décomposition du signal reçu comprend une entrée et N sorties, chaque sortie étant connectée à une entrée respective d'un corrélateur respectif. Le multiplexeur MUX comporte N entrées et une sortie, chaque entrée étant connectée à une sortie respective d'un corrélateur respectif.

Le dispositif DEC est configuré pour aiguiller chaque échantillon reçu en entrée successivement vers une sortie différente, afin de produire sur chaque sortie un signal sous-échantillonné d'un facteur N par rapport au signal d'entrée. Chacun des signaux produit en sortie du dispositif DEC est décalé temporellement d'un retard égal à T/N.

Le multiplexeur MUX est configuré pour entrelacer les N signaux reçus sur ses N entrées afin de produire un unique réflectogramme R(n) dont la résolution temporelle est augmentée d'un facteur N par rapport au réflectogramme qui serait obtenu en utilisant le système de la figure 1.

Le système selon l'une quelconque des variantes de réalisation de l'invention peut être mis en œuvre par une carte électronique sur laquelle sont disposés les différents composants. La carte peut être connectée au(x) câble(s) à analyser par un ou plusieurs moyen(s) de couplage CPL qui peuvent prendre la forme d'un coupleur directionnel à effet capacitif ou inductif ou encore une connexion ohmique. Un dispositif de couplage peut être réalisé par des connecteurs physiques qui relient le générateur de signal au câble ou par des moyens sans contact, par exemple en utilisant un cylindre métallique dont le diamètre interne est sensiblement égal au diamètre externe du câble et qui produit un effet de couplage capacitif avec le câble.

En outre, une unité de traitement, de type ordinateur, assistant numérique personnel ou autre dispositif électronique ou informatique équivalent peut être utilisé pour piloter le système selon l'invention et afficher les résultats des calculs effectués par le ou les corrélateurs sur une interface homme-machine, en particulier le réflectogramme R(n) et/ou les informations de détection et localisation de défauts sur le câble.

Le procédé selon l'invention, en particulier les modules de calcul de corrélation peuvent être implémentés dans un processeur embarqué ou non ou dans un dispositif spécifique. Le processeur peut être un processeur générique, un processeur spécifique, un circuit intégré propre à une application (connu aussi sous le nom anglais d'ASIC pour « Application-Specific Integrated Circuit ») ou un réseau de portes programmables in situ (connu aussi sous le nom anglais de FPGA pour « Field-Programmable Gâte Array »). Le dispositif selon l'invention peut utiliser un ou plusieurs circuits électroniques dédiés ou un circuit à usage général. La technique de l'invention peut se réaliser sur une machine de calcul reprogrammable (un processeur ou un micro-contrôleur par exemple) exécutant un programme comprenant une séquence d'instructions, ou sur une machine de calcul dédiée (par exemple un ensemble de portes logiques comme un FPGA ou un ASIC, ou tout autre module matériel).

Le système de réflectométrie selon l'invention peut comporter, au sein d'un même dispositif, à la fois les composants aptes à générer le signal de référence et à l'injecter dans une ou plusieurs ligne(s) de transmission et les composants aptes à mesurer le signal rétro-propagé et à réaliser les calculs nécessaires à l'élaboration d'un réflectogramme. Alternativement, ces deux parties peuvent être implémentées sur deux dispositifs distincts, chaque dispositif étant connecté indépendamment au câble à analyser.

**Revendications**

1. Système de réflectométrie (400,500,501,600,601) pour l'analyse de défauts dans un groupe de lignes de transmission comprenant au moins une ligne $(L,L_1,L_2)$, un signal de référence réel généré étant injecté dans chaque ligne

de transmission (L,L$_1$,L$_2$) dudit groupe, ledit système comprenant :

> • au moins un moyen de mesure (CPL,CPL$_1$,CPL$_2$) du signal de référence rétro-propagé dans chaque ligne de transmission (L,L$_1$,L$_2$) dudit groupe,
> • au moins un convertisseur analogique-numérique (ADC,ADC$_1$,ADC$_2$) pour convertir au moins un signal mesuré en un ensemble d'au moins un premier signal numérique et un deuxième signal numérique,
> • au moins un corrélateur complexe (COR,COR$_1$,COR$_2$) configuré pour corréler le signal de référence réel avec un signal complexe dont la partie réelle est formée par un premier signal numérique dudit ensemble et la partie imaginaire est formée par un deuxième signal numérique dudit ensemble, afin de produire un premier réflectogramme correspondant à la partie réelle du signal complexe et un second réflectogramme correspondant à la partie imaginaire du signal complexe,
> • Un module d'analyse d'au moins le premier réflectogramme et le second réflectogramme pour identifier la présence de défauts dans au moins une ligne de transmission dudit groupe.

2. Système de réflectométrie selon la revendication 1 dans lequel un corrélateur complexe (COR,COR$_1$,COR$_2$) comprend un premier module de transformée de Fourier (TFD$_2$) apte à recevoir sur une entrée le signal de référence et dont la seconde entrée est mise à zéro, un second module de transformée de Fourier (TFD$_1$) apte à recevoir le premier signal numérique sur une première entrée et le deuxième signal numérique sur une seconde entrée, un multiplieur (MUL) agencé pour multiplier un signal complexe délivré en sortie du premier module de transformée de Fourier (TFD$_2$) avec un signal complexe délivré en sortie du second module de transformée de Fourier (TFD$_1$), et un module de transformée de Fourier inverse (TFDI) agencé pour recevoir le signal complexe délivré en sortie du multiplieur (MUL) et fournir en sortie le premier réflectogramme sur une voie réelle et le second réflectogramme sur une voie imaginaire.

3. Système de réflectométrie selon l'une des revendications précédentes dans lequel ledit groupe de lignes de transmission comprend deux lignes de transmission (L$_1$,L$_2$), ledit système comprenant deux convertisseurs analogique-numérique (ADC$_1$,ADC$_2$), le premier signal numérique et le second signal numérique correspondant aux deux lignes de transmission respectives (L$_1$,L$_2$).

4. Système de réflectométrie selon l'une des revendications 1 ou 2 dans lequel ledit groupe de lignes de transmission comprend une unique ligne (L), ledit système comprenant un unique convertisseur analogique-numérique (ADC), un dispositif (DEC) pour décomposer un signal en plusieurs signaux, à une entrée et un nombre N de sorties pair, configuré pour recevoir le signal numérique converti et pour délivrer, sur chaque sortie, une version sous-échantillonnée du signal d'entrée d'un facteur N, et un multiplexeur (MUX), à N entrées et une sortie, dont chaque entrée est reliée à une sortie respective d'un corrélateur complexe, le multiplexeur (MUX) étant configuré pour produire en sortie un unique réflectogramme à partir d'au moins le premier réflectogramme et le deuxième réflectogramme, ledit système comprenant un nombre N/2 de corrélateurs complexes.

5. Système de réflectométrie selon la revendication 4 dans lequel le dispositif (DEC) pour décomposer un signal en plusieurs signaux est configuré pour transmettre chaque nouvel échantillon reçu en entrée vers une nouvelle sortie d'indice incrémenté de un modulo N, et le multiplexeur (MUX) est configuré pour délivrer en sortie, à chaque nouvel instant, un nouvel échantillon reçu sur une nouvelle entrée d'indice incrémenté de un modulo N à chaque nouvel instant.

6. Système de réflectométrie selon l'une des revendications 4 ou 5 dans lequel la fréquence d'échantillonnage (Fe$_{ADC}$) du convertisseur analogique numérique est sensiblement égale à N fois la fréquence d'échantillonnage (Fe$_{DAC}$) du signal injecté dans la ligne et la fréquence de traitement (Fcor) du ou des corrélateur(s) complexe(s) (COR,COR$_1$,COR$_2$) est supérieure ou égale à la fréquence d'échantillonnage (Fe$_{DAC}$) du signal injecté dans la ligne et strictement inférieure à la fréquence d'échantillonnage du convertisseur analogique-numérique (Fe$_{ADC}$).

7. Système de réflectométrie selon la revendication 4 dans lequel le dispositif (DEC) pour décomposer un signal en plusieurs signaux est configuré pour, transmettre chaque nouveau bloc d'échantillons reçus en entrée vers une nouvelle sortie d'indice incrémenté de un modulo N et le multiplexeur (MUX) est configuré pour délivrer en sortie, à chaque nouvel instant, un nouveau bloc d'échantillons reçus sur une nouvelle entrée d'indice incrémenté de un modulo N à chaque nouvel instant, le système comprenant en outre un nombre N de mémoires FIFO d'entrée (FIFO$_{e1}$,FIFO$_{e2}$) étant chacune connectée entre une sortie distincte du dispositif (DEC) pour décomposer un signal en plusieurs signaux et une entrée distincte d'un corrélateur complexe distinct (COR), le système comprenant aussi un nombre N de mémoires FIFO de sortie (FIFO$_{s1}$,FIFO$_{s2}$) étant chacune connectée entre une sortie distincte d'un corrélateur complexe distinct (COR) et une entrée distincte du multiplexeur (MUX).

8. Système de réflectométrie selon la revendication 6 dans lequel le signal de référence est périodique et le nombre d'échantillons par bloc est égal au nombre d'échantillons par période du signal de référence.

9. Système de réflectométrie selon l'une des revendications 4, 7 ou 8 dans lequel la fréquence d'échantillonnage du convertisseur analogique-numérique ($Fe_{ADC}$) est sensiblement égale à la fréquence d'échantillonnage ($Fe_{DAC}$) du signal injecté dans la ligne et la fréquence de traitement ($F_{cor}$) du ou des corrélateur(s) complexe(s) ($COR,COR_1,COR_2$) est au moins égale à la fréquence d'échantillonnage du convertisseur analogique-numérique ($Fe_{ADC}$) divisée par N et strictement inférieure à la fréquence d'échantillonnage du convertisseur analogique-numérique ($Fe_{ADC}$), divisée par (N-2) si N est différent de deux.

10. Système de réflectométrie selon l'une des revendications précédentes comprenant un générateur du signal de référence (GEN), au moins un convertisseur numérique-analogique (DAC) et au moins un dispositif d'injection ($CPL,CPL_1,CPL_2$) pour injecter le signal de référence analogique dans chaque ligne de transmission ($L,L_1,L_2$) dudit groupe.

**Patentansprüche**

1. Reflektometriesystem (400, 500, 501, 600, 601) zur Analyse von Defekten in einer Gruppe von Übertragungsleitungen, die mindestens eine Leitung ($L$, $L_1$, $L_2$) umfasst, wobei ein reales, erzeugtes Referenzsignal in jede Übertragungsleitung ($L$, $L_1$, $L_2$) der Gruppe eingespeist wird, wobei das System Folgendes umfasst:

    • mindestens ein Mittel ($CPL$, $CPL_1$, $CPL_2$) zum Messen des Referenzsignals, das sich in jeder Übertragungsleitung ($L$, $L_1$, $L_2$) der Gruppe rückwärts ausbreitet,
    • mindestens einen Analog-Digital-Wandler ($ADC$, $ADC_1$, $ADC_2$) zum Umwandeln mindestens eines gemessenen Signals in einen Satz aus mindestens einem ersten digitalen Signal und einem zweiten digitalen Signal,
    • mindestens einen komplexen Korrelator ($COR$, $COR_1$, $COR_2$), konfiguriert zum Korrelieren des realen Referenzsignals mit einem komplexen Signal, dessen Realteil durch ein erstes digitales Signal des Satzes gebildet wird und dessen Imaginärteil durch ein zweites digitales Signal des Satzes gebildet wird, um ein erstes Reflektogramm entsprechend dem Realteil des komplexen Signals und ein zweites Reflektogramm entsprechend dem Imaginärteil des komplexen Signals zu erzeugen,
    • ein Modul zum Analysieren mindestens des ersten Reflektogramms und des zweiten Reflektogramms, um das Vorliegen von Defekten in mindestens einer Übertragungsleitung der genannten Gruppe zu identifizieren.

2. Reflektometriesystem nach Anspruch 1, wobei ein komplexer Korrelator ($COR$, $COR_1$, $COR_2$) ein erstes Fourier-Transformationsmodul ($TFD_2$), das zum Empfangen des Referenzsignals an einem Eingang ausgelegt und dessen zweiter Eingang auf Null gesetzt ist, ein zweites Fourier-Transformationsmodul ($TFD_1$), das zum Empfangen des ersten digitalen Signals an einem ersten Eingang und des zweiten digitalen Signals an einem zweiten Eingang ausgelegt ist, einen Multiplizierer (MUL), der zum Multiplizieren eines am Ausgang des ersten Fourier-Transformationsmoduls ($TFD_2$) ausgegebenen komplexen Signals mit einem am Ausgang des zweiten Fourier-Transformationsmoduls ($TFD_1$) ausgegebenen komplexen Signal ausgelegt ist, und ein inverses Fourier-Transformationsmodul (TFDI), das zum Empfangen des am Ausgang des Multiplizierers (MUL) ausgegebenen komplexen Signals und zum Ausgeben des ersten Reflektogramms auf einem realen Kanal und des zweiten Reflektogramms auf einem imaginären Kanal ausgelegt ist, umfasst.

3. Reflektometriesystem nach einem der vorherigen Ansprüche, wobei die Gruppe von Übertragungsleitungen zwei Übertragungsleitungen ($L_1$, $L_2$) umfasst, wobei das System zwei Analog-Digital-Wandler ($ADC_1$, $ADC_2$) umfasst, wobei das erste digitale Signal und das zweite digitale Signal den beiden jeweiligen Übertragungsleitungen ($L_1$, $L_2$) entsprechen.

4. Reflektometriesystem nach einem der Ansprüche 1 oder 2, wobei die Gruppe von Übertragungsleitungen eine einzelne Leitung ($L$) umfasst, wobei das System einen einzelnen Analog-Digital-Wandler (ADC), ein Gerät (DEC) zum Zerlegen eines Signals in mehrere Signale, mit einem Eingang und einer geraden Anzahl N von Ausgängen, die zum Empfangen des umgewandelten digitalen Signals und zum Ausgeben, an jedem Ausgang, einer um einen Faktor N unterabgetasteten Version des Eingangssignals konfiguriert ist, und einen Multiplexer (MUX) mit N Eingängen und einem Ausgang umfasst, von dem jeder Eingang mit einem jeweiligen Ausgang eines komplexen Korrelators verbunden ist, wobei der Multiplexer (MUX) zum Erzeugen eines einzelnen Reflektogramms aus mindestens dem ersten Reflektogramm und dem zweiten Reflektogramm am Ausgang konfiguriert ist, wobei das System eine Anzahl N/2 von komplexen Korrelatoren umfasst.

5. Reflektometriesystem nach Anspruch 4, wobei das Gerät (DEC) zum Zerlegen eines Signals in mehrere Signale zum Übertragen jedes am Eingang empfangenen neuen Sample zu einem neuen, um ein Modulo N inkrementierten Indexausgang konfiguriert ist, und der Multiplexer (MUX) zum Ausgeben, zu jedem neuen Zeitpunkt, eines neuen Sample das an einem neuen, um ein Modulo N inkrementierten Indexeingang zu jedem neuen Zeitpunkt empfangen wird, konfiguriert ist.

6. Reflektometriesystem nach Anspruch 4 oder 5, wobei die Abtastfrequenz ($Fe_{ADC}$) des Analog-Digital-Wandlers im Wesentlichen gleich dem N-fachen der Abtastfrequenz ($Fe_{DAC}$) des in die Leitung eingespeisten Signals ist und die Verarbeitungsfrequenz (Fcor) des/der komplexen Korrelators/-en (COR, $COR_1$, $COR_2$) gleich der oder größer als die Abtastfrequenz ($Fe_{DAC}$) des in die Leitung eingespeisten Signals und strikt kleiner als die Abtastfrequenz des Analog-Digital-Wandlers ($Fe_{ADC}$) ist.

7. Reflektometriesystem nach Anspruch 4, wobei das Gerät (DEC) zum Zerlegen eines Signals in mehrere Signale zum Übertragen jedes neuen Blocks von am Eingang empfangenen Samples zu einem neuen, um ein Modulo N inkrementierten Indexausgang konfiguriert ist, und der Multiplexer (MUX) zum Ausgeben, zu jedem neuen Zeitpunkt, eines neuen Blocks von an einem neuen, um ein Modulo N inkrementierten Indexeingang zu jedem neuen Zeitpunkt empfangenen Samples konfiguriert ist, wobei das System ferner eine Anzahl N von Eingangs-FIFO-Speichern ($FIFO_{e1}$, $FIFO_{e2}$) umfasst, die jeweils zwischen einem separaten Ausgang des Geräts (DEC) zum Zerlegen eines Signals in mehrere Signale und einem separaten Eingang eines separaten komplexen Korrelators (COR) angeschlossen sind, wobei das System auch eine Anzahl N von Ausgangs-FIFO-Speichern ($FIFO_{s1}$, $FIFO_{s2}$) umfasst, die jeweils zwischen einem separaten Ausgang eines separaten komplexen Korrelators (COR) und einem separaten Eingang des Multiplexers (MUX) angeschlossen sind.

8. Reflektometriesystem nach Anspruch 6, wobei das Referenzsignal periodisch ist und die Anzahl von Samples pro Block gleich der Anzahl von Samples pro Periode des Referenzsignals ist.

9. Reflektometriesystem nach einem der Ansprüche 4, 7 oder 8, wobei die Abtastfrequenz des Analog-Digital-Wandlers ($Fe_{ADC}$) im Wesentlichen gleich der Abtastfrequenz ($Fe_{DAC}$) des in die Leitung eingespeisten Signals ist und die Verarbeitungsfrequenz ($F_{cor}$) des/der komplexen Korrelators/-en (COR, $COR_1$, $COR_2$) mindestens gleich der Abtastfrequenz des Analog-Digital-Wandlers ($Fe_{ADC}$) dividiert durch N und strikt kleiner als die Abtastfrequenz des Analog-Digital-Wandlers ($Fe_{ADC}$), dividiert durch (N-2) ist, wenn sich N von zwei unterscheidet.

10. Reflektometriesystem nach einem der vorherigen Ansprüche, das einen Generator (GEN) des Referenzsignals, mindestens einen Digital-Analog-Wandler (DAC) und mindestens ein Einspeisegerät (CPL, $CPL_1$, $CPL_2$) zum Einspeisen des analogen Referenzsignals in jede Übertragungsleitung (L, $L_1$, $L_2$) der Gruppe umfasst.

**Claims**

1. A reflectometry system (400, 500, 501, 600, 601) for the analysis of defects in a group of transmission lines comprising at least one line (L, $L_1$, $L_2$), a generated real reference signal being injected into each transmission line (L, $L_1$, $L_2$) of said group, said system comprising:

> • at least one measurement means (CPL, $CPL_1$, $CPL_2$) for measuring the reference signal retro-propagated in each transmission line (L, $L_1$, $L_2$) of said group,
> • at least one analog-digital converter (ADC, $ADC_1$, $ADC_2$) for converting at least one measured signal into a set of at least one first digital signal and one second digital signal,
> • at least one complex correlator (COR, $COR_1$, $COR_2$) configured to correlate the real reference signal with a complex signal whose real part is formed by a first digital signal of said set and whose imaginary part is formed by a second digital signal of said set, so as to produce a first reflectogram corresponding to the real part of the complex signal and a second reflectogram corresponding to the imaginary part of the complex signal,
> • an analysis module for analyzing at least the first reflectogram and the second reflectogram so as to identify the presence of defects in at least one transmission line of said group.

2. The reflectometry system according to claim 1, wherein a complex correlator (COR, COR$_1$, COR$_2$) comprises a first Fourier transform module (TFD$_2$) able to receive on an input the reference signal and whose second input is set to zero, a second Fourier transform module (TFD$_1$) able to receive the first digital signal on a first input and the second digital signal on a second input, a multiplier (MUL) designed to multiply a complex signal delivered as output of the first Fourier transform module (TFD$_2$) with a complex signal delivered as output of the second Fourier transform module (TFD$_1$), and an inverse Fourier transform module (TFDI) designed to receive the complex signal delivered as output of the multiplier (MUL) and provide as output the first reflectogram on a real pathway and the second reflectogram on an imaginary pathway.

3. The reflectometry system according to one of the preceding claims, wherein said group of transmission lines comprises two transmission lines (L$_1$, L$_2$), said system comprising two analog-digital converters (ADC$_1$, ADC$_2$), the first digital signal and the second digital signal corresponding to the two respective transmission lines (L$_1$, L$_2$).

4. The reflectometry system according to one of claims 1 or 2, wherein said group of transmission lines comprises a single line (L), said system comprising a single analog-digital converter (ADC), a device (DEC) for decomposing a signal into several signals, with one input and an even number N of outputs, which is configured to receive the converted digital signal and to deliver, on each output, an undersampled, by a factor N, version of the input signal, and a multiplexer (MUX), with N inputs and one output, each input of which is linked to a respective output of a complex correlator, the multiplexer (MUX) being configured to produce as output a single reflectogram from at least the first reflectogram and the second reflectogram, said system comprising a number N/2 of complex correlators.

5. The reflectometry system according to claim 4, wherein the device (DEC) for decomposing a signal into several signals is configured to transmit each new sample received as input to a new output of index incremented by one modulo N, and the multiplexer (MUX) is configured to deliver as output, at each new instant, a new sample received on a new input of index incremented by one modulo N at each new instant.

6. The reflectometry system according to one of claims 4 or 5, wherein the sampling frequency (Fe$_{ADC}$) of the analog-digital converter is substantially equal to N times the sampling frequency (Fe$_{DAC}$) of the signal injected into the line and the processing frequency (Fcor) of the complex correlator(s) (COR, COR$_1$, COR$_2$) is greater than or equal to the sampling frequency (Fe$_{DAC}$) of the signal injected into the line and strictly lower than the sampling frequency of the analog-digital converter (Fe$_{ADC}$).

7. The reflectometry system according to claim 4, wherein the device (DEC) for decomposing a signal into several signals is configured to transmit each new block of samples received as input to a new output of index incremented by one modulo N and the multiplexer (MUX) is configured to deliver as output, at each new instant, a new block of samples received on a new input of index incremented by one modulo N at each new instant, the system further comprising a number N of input FIFO memories (FIFO$_{e1}$, FIFO$_{e2}$), each being connected between a distinct output of the device (DEC) for decomposing a signal into several signals and a distinct input of a distinct complex correlator (COR), the system also comprising a number N of output FIFO memories (FIFO$_{s1}$, FIFO$_{s2}$), each being connected between a distinct output of a distinct complex correlator (COR) and a distinct input of the multiplexer (MUX).

8. The reflectometry system according to claim 6, wherein the reference signal is periodic and the number of samples per block is equal to the number of samples per period of the reference signal.

9. The reflectometry system according to one of claims 4, 7 or 8, wherein the sampling frequency of the analog-digital converter (Fe$_{ADC}$) is substantially equal to the sampling frequency (Fe$_{DAC}$) of the signal injected into the line and the processing frequency (F$_{cor}$) of the complex correlator(s) (COR, COR$_1$, COR$_2$) is at least equal to the sampling frequency of the analog-digital converter (Fe$_{ADC}$) divided by N and strictly lower than the sampling frequency of the analog-digital converter (Fe$_{ADC}$), divided by (N-2) if N is different from two.

10. The reflectometry system according to one of the preceding claims, comprising a generator of the reference signal (GEN), at least one digital-analog converter (DAC) and at least one injection device (CPL, CPL$_1$, CPL$_2$) for injecting the analog reference signal into each transmission line (L, L$_1$, L$_2$) of said group.

FIG.1

FIG.1bis

FIG.2

FIG.3

FIG.4

FIG.5a

EP 3 658 926 B1

FIG.5b

600

L

CPL

DAC

$Fe_{DAC}$

ADC

$Fe_{ADC}$

DEC

GEN

a[0],a[1],...a[n-1]
b[0],b[1],...b[n-1]
c[0],c[1],...c[n-1]

a[0],a[1],...a[n-1]
b[0],b[1],...b[n-1]
c[0],c[1],...c[n-1]

Re

Im

$a[n](t)$

$a[n](t+T/2)$

$TFD_1$

a'[0],a'[1],...a'[n-1]
b'[0],b'[1],...b'[n-1]
c'[0],c'[1],...c'[n-1]

Re

Im

$TFD_2$

Im

Re

MUL

Re

Im

COR

Re

Im

TFDI

Re

Im

(a*r)[0],... (a*r)[n-1]
(b*r)[0],... (b*r)[n-1]
(c*r)[0],... (c*r)[n-1]

(a'*r)[0],... (a'*r)[ [n-1]
(b'*r)[0],... (b'*r)[ [n-1]
(c'*r)[0],... (c'*r)[ [n-1]

R(n)

MUX

FIG.6a

20

FIG.6b

EP 3 658 926 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3006769 A1